# DEMANDE DE BREVET EUROPEEN

(11) **EP 0 755 081 A1**
(43) Date de publication de la demande: **22.01.1997**
(21) Numéro de dépôt: 96401626.5
(22) Date de dépôt: 19.07.1996
(51) Int. Cl.: H01L 31/105, H01L 31/20, H01L 27/146

(54) **Structure photosensible durcie aux rayonnements électromagnétiques durs et son application aux caméras vidéo**

(30) Priorité: 21.07.1995 FR 9508881
(71) Demandeur: COMMISSARIAT A L'ENERGIE ATOMIQUE, 75015 Paris (FR)
(72) Inventeur: Pochet, Thierry, 78830 Bonnelles (FR)
(74) Mandataire: Dubois-Chabert, Guy

(57) **Abrégé**

L'invention concerne une structure photosensible destinée à capter la lumière et à délivrer un signal électrique représentatif de la lumière captée, la structure présentant une résistance aux rayonnements électromagnétiques durs et comportant un élément photosensible en silicium amorphe hydrogéné (1) et des moyens (3, 4) pour recueillir les charges électriques induites par effet photoélectrique dans ledit élément photosensible captant la lumière et pour délivrer ledit signal électrique.

Elle concerne également un dispositif comprenant au moins une telle structure photosensible connectée électriquement à des moyens électroniques de traitement (5) dudit signal électrique.

Application à la réalisation d'un capteur optique pour caméra vidéo.

## Description

La présente invention concerne une structure photosensible présentant une résistance aux rayonnements électromagnétiques durs. Elle concerne aussi un dispositif photosensible associant une telle structure à des circuits électroniques de traitement du signal électrique délivré par cette structure. L'invention s'applique notamment à la réalisation de caméras vidéo résistant aux rayonnements électromagnétiques durs en particulier et, de manière plus générale, aux rayonnements nucléaires.

Les industries oeuvrant sous environnement fortement hostile en terme de rayonnement nucléaire utilisent des systèmes de perception à distance de l'environnement en raison de la contamination de cet environnement ou à cause de la présence de rayonnements ionisants dangereux pour l'intervention humaine directe. Parmi les systèmes utilisés, on compte les caméras vidéo fonctionnant dans le domaine visible et permettant la surveillance d'installations ou le contrôle du déroulement de procédés industriels.

Le système de caméra doit satisfaire certaines caractéristiques propres au milieu où il est destiné. Ces caractéristiques sont principalement de deux ordres. Le système de caméra doit pouvoir absorber une dose d'au moins 10 MRad. Il doit être opérationnel et restituer une image peu bruitée sous un débit de dose de 100 kRad/h.

Actuellement, les systèmes de caméra capables de satisfaire ces caractéristiques utilisent des tubes Vidicon. Ces tubes sont issus d'une technologie vieillissante et qui est amenée à disparaître à moyen terme. On songe depuis longtemps déjà à des solutions de remplacement. Cependant, malgré les sommes importantes dépensées pour apporter une solution à ce problème, aucune étude n'a jusqu'à présent abouti à un résultat satisfaisant.

Les solutions à base de caméras vidéo standard de type à transfert de charges (CCD) sont séduisantes mais ne peuvent être mises en oeuvre. En effet, les dispositifs à transfert de charge sont élaborés à partir d'un substrat en silicium cristallin, matériau dont la qualité cristalline se détériore sous une exposition à des rayonnements ionisants. Les caméras vidéo CCD dont l'élément sensible est une matrice CCD ne sont donc pas adaptées aux ambiances fortement hostiles où leur durée de vie est au mieux de l'ordre de quelques centaines de kRad.

Afin de remédier à ces inconvénients, la présente invention propose l'utilisation d'une couche photosensible en silicium amorphe hydrogéné. L'inventeur de la présente invention a constaté que ce matériau est beaucoup moins sensible aux rayonnements ionisants que le silicium cristallin et qu'il peut donc être avantageusement utilisé pour constituer des éléments photosensibles (ou rétine) de caméras vidéo destinées à fonctionner en présence de rayonnements ionisants. Un avantage supplémentaire est constitué par le faible coût de la technologie des dispositifs réalisés en silicium amorphe hydrogéné par rapport à la technologie des dispositifs réalisés en silicium monocristallin.

L'invention a donc pour objet une structure photosensible destinée à capter la lumière et à délivrer un signal électrique représentatif de la lumière captée, la structure présentant une résistance aux rayonnements électromagnétiques durs, caractérisée en ce qu'elle comporte un élément photosensible en silicium amorphe hydrogéné et des moyens pour recueillir les charges électriques induites par effet photoélectrique dans ledit élément photosensible captant la lumière et pour délivrer ledit signal électrique.

Tous les éléments photosensibles en silicium amorphe hydrogéné peuvent convenir. Par exemple, cet élément photosensible en silicium amorphe hydrogéné peut constituer une jonction présentant une zone déplétée.

L'élément photosensible en silicium amorphe hydrogéné peut préférentiellement constituer une jonction bipolaire de type p-i-n.

Dans ce dernier cas, la jonction présentant à la lumière à capter la succession de couches p, i et n, l'épaisseur de l'élément photosensible est comprise entre 0,5 et 2 µm.

La couche **p** de la jonction bipolaire de type p-i-n peut avoir une épaisseur de l'ordre de 10% de l'épaisseur de l'élément photosensible. Elle peut être en alliage de silicium et de carbone.

Les moyens pour recueillir les charges électriques et pour délivrer ledit signal électrique peuvent comprendre une électrode transparente à la lumière déposée sur la face de l'élément photosensible recevant la lumière à capter et une électrode déposée sur l'autre face de l'élément photosensible.

L'invention a aussi pour objet un dispositif photosensible caractérisé en ce qu'il comprend au moins une structure photosensible telle que décrite ci-dessus, connectée électriquement à des moyens électroniques de traitement dudit signal électrique.

Ce dispositif peut comporter une pluralité de structures photosensibles pour constituer un capteur optique.

Les structures photosensibles peuvent être connectées électriquement aux moyens électroniques de traitement par l'intermédiaire de billes conductrices.

Elles peuvent aussi être déposées directement sur les moyens électroniques de traitement réalisant ainsi la connexion électrique entre les structures photosensibles et les moyens électroniques de traitement.

Ce dispositif photosensible peut être avantageusement utilisé pour constituer le capteur optique d'une caméra vidéo.

L'invention concerne enfin un procédé de traitement d'un élément photosensible en silicium amorphe hydrogéné ayant été soumis à une irradiation par des rayonnements électromagnétiques durs pour lui restituer ses performances avant irradiation et qui ont été dégradées par cette irradiation, caractérisé en ce qu'il consiste à chauffer l'élément photosensible.

Ce traitement peut consister à chauffer l'élément photosensible à une température de l'ordre de 80°C pendant quelques heures, typiquement deux heures.

L'invention sera mieux comprise et d'autres avantages et particularités apparaîtront à la lecture de la description qui va suivre, donnée à titre d'exemple non limitatif, et accompagnée des dessins annexés parmi lesquels :
- la figure 1 est une vue de côté d'une première variante de dispositif photosensible selon l'invention,
- la figure 2 est une vue de côté d'une seconde variante de dispositif photosensible selon l'invention,
- les figures 3A, 3B et 3C représentent trois étapes mises en oeuvre dans un procédé de fabrication d'un dispositif photosensible destiné à servir de capteur optique pour une caméra vidéo.

L'invention va maintenant être décrite dans ses applications les plus pertinentes, c'est-à-dire un système de détection de la lumière visible et une caméra vidéo.

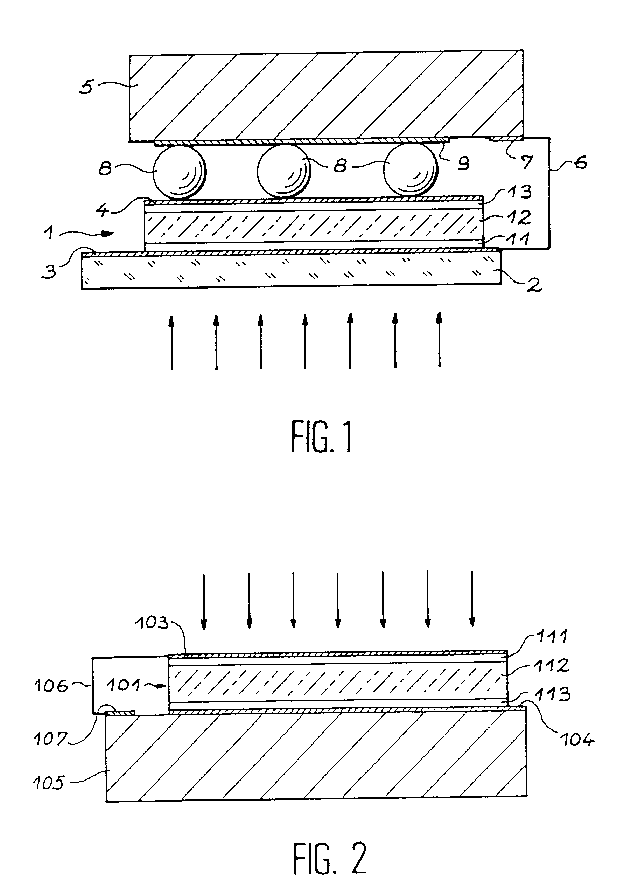

L'élément photosensible en silicium amorphe hydrogéné du dispositif représenté à la figure 1 est une jonction bipolaire de type p-i-n. Lajonction p-i-n 1 comprend une couche **p** référencée 11, une couche **i** référencée 12 et une couche **n** référencée 13. La jonction 1 est disposée sur un support transparent 2 qui assure la tenue mécanique de l'ensemble ainsi que la transmission de la lumière. Elle est comprise entre deux électrodes : une première électrode 3 transparente à la lumière et disposée sur la couche 11 (la couche **p**) et donc intercalée entre la jonction bipolaire 1 et le support 2, et une deuxième électrode 4 déposée sur la couche 13 (la couche **n**). L'électrode 3 transparente est par exemple réalisée en oxyde d'étain ou en oxyde mixte d'étain et d'indium. L'électrode 4 est une couche métallique quelconque, par exemple en chrome ou en aluminium.

Les électrodes 3 et 4 permettent de recueillir les charges électriques induites par effet photoélectrique dans la jonction bipolaire 1 par un faisceau lumineux (représenté par des flèches) traversant le support transparent 2 et l'électrode transparente 3. Un signal électrique est donc disponible entre les électrodes 3 et 4 et peut être traité par un circuit électronique, connu de l'homme du métier, pour restituer une image par exemple sur un écran de contrôle.

La connexion électrique entre les électrodes 3 et 4 du dispositif et le circuit électronique de traitement 5 peut être obtenue comme suit. Une liaison conductrice 6 relie l'électrode 3 se prolongeant sur le support 2 à une borne d'entrée correspondante 7 du circuit électronique 5. Des billes conductrices 8, par exemple en indium, permettent de relier électriquement l'électrode 4 à la borne d'entrée correspondante 9 du circuit de traitement 5. Cette technique d'interconnexion est connue par le document FR-A-2 646 558.

Dans la variante de réalisation représentée à la figure 2, la jonction 101 comprend, comme précédemment, une couche **p** référencée 111, une couche **i** référencée 112 et une couche **n** référencée 113. La couche **p** est recouverte d'une électrode transparente 103, par exemple en oxyde d'étain ou en oxyde mixte d'étain et d'indium. L'électrode 103 laisse passer un faisceau lumineux incident symbolisé par les flèches. L'électrode 104 est une couche métallique constituant une interface électrique entre la couche **n** de la jonction 101 et une borne d'entrée correspondante du circuit électronique de traitement 105. Une liaison conductrice 106 relie l'électrode 103 de la jonction 101 et une borne d'entrée correspondante 107 du circuit électronique de traitement 105. Ce circuit 105 assure donc la tenue mécanique de l'ensemble.

L'épaisseur de la jonction bipolaire de type p-i-n, adaptée à l'absorption de lumière artificielle ou naturelle, varie de 0,5 µm à 2 µm. La surface que présente cette jonction à un faisceau lumineux incident peut être comprise entre 1 et 2500 µm² selon la sensibilité recherchée.

L'invention s'applique particulièrement bien à la réalisation de caméras vidéo. La tête d'une caméra vidéo type CCD est essentiellement composée de deux parties. Une première partie comprend un ensemble d'éléments photosensibles (de quelques dizaines à plusieurs centaines de milliers) dont le rôle consiste à absorber le plus possible de lumière et à convertir les photons en électrons. Une deuxième partie est constituée par la matrice de lecture qui permet de traiter puis de récupérer les charges photogénérées élément d'image par élément d'image, par exemple de manière séquentielle, et de les acheminer vers l'électronique traditionnelle de traitement dont le rôle est de reconstituer l'image.

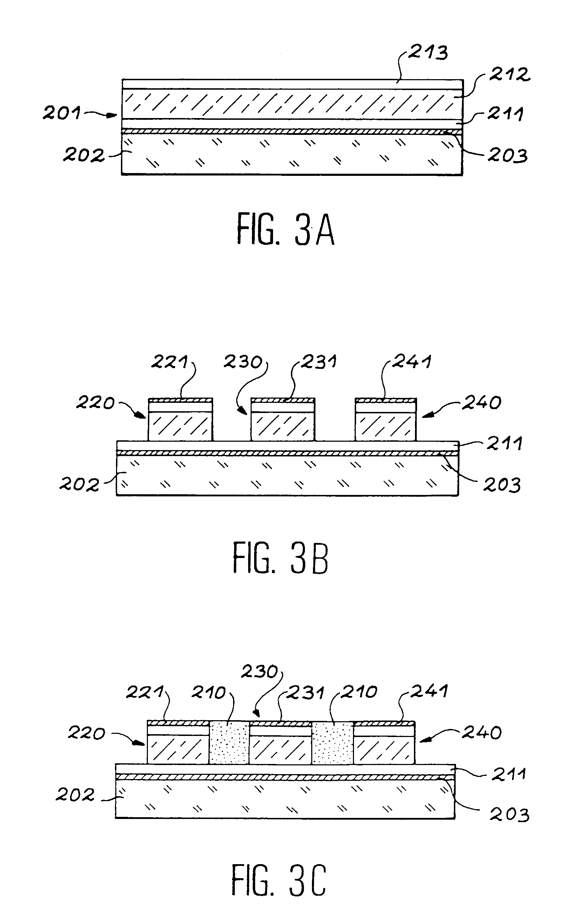

La présente invention permet d'obtenir un ensemble d'éléments photosensibles durci aux rayonnements électromagnétiques durs, organisé sous forme de matrice. Cet ensemble d'éléments peut être réalisé par un procédé utilisé habituellement en microélectronique comme cela est illustré par les figures 3A, 3B et 3C. Ces figures sont des vues de côté du dispositif et ne montrent que trois éléments photosensibles par souci de simplification. L'ensemble est du type de la figure 1, c'est-à-dire élaboré à partir d'un support transparent. Cependant le même procédé peut s'appliquer à un ensemble du type de la figure 2.

La figure 3A montre un support transparent 202 (par exemple en verre) sur lequel on a déposé une succession de couches uniformes : une couche électriquement conductrice et transparente 203 (par exemple en oxyde mixte d'étain et d'indium) et trois couches de silicium amorphe hydrogéné (une couche **p** référencée 211, une couche **i** référencée 212 et une couche **n** référencée 213).

Par un procédé standard de lithographie (masquage), on délimite ensuite par gravure les éléments photosensibles. C'est ce que montre la figure 3B où trois éléments photosensibles 220, 230 et 240 sont en cours d'élaboration. Ces éléments photosensibles sont recouverts sur leur couche **n** d'une électrode métallique 221, 231 et 241.

La gravure des éléments photosensibles peut être réalisée par attaque chimique ou par plasma. La gravure permet d'éviter entre autres les courants de fuite de surface entre les éléments d'image. On remarque que la couche **p** (ou couche 211) a été gardée uniforme, ce qui ne nuit pas au fonctionnement du dispositif.

Comme le montre la figure 3C, une phase de passivation peut ensuite être effectuée pour combler les espaces 210 entre les éléments d'image par de l'oxyde de silicium SiO₂ ou du nitrure de silicium Si₃N₄ par exemple.

Le silicium amorphe hydrogéné peut être déposé grâce à un réacteur à plasma dans lequel un gaz (le silane) est dissocié et dont les résidus (le silicium) se déposent sur un substrat ou support et forment une couche mince de matériau semiconducteur. La couche **p** peut éventuellement contenir du carbone (environ 10 à 20%) afin d'accroître la bande interdite et ainsi de limiter l'absorption de la lumière dans cette zone morte.

Il peut être nécessaire de polariser légèrement en inverse les jonctions p-i-n, entre 1 et 10 V selon l'épaisseur du dispositif. Il sera donc important de limiter le courant de fuite induit par la polarisation. Ceci peut être obtenu en réalisant des couches **p** relativement épaisses (de l'ordre de 10% de l'épaisseur de la jonction p-i-n).

Le matériau utilisé pour réaliser les éléments photosensibles selon la présente invention est faiblement sensible aux rayonnements ionisants. Des mesures ont montré qu'il permet de remédier aux problèmes de l'art connu. A partir d'une dose de 6 MRad, on constate une légère dégradation du courant de fuite du dispositif mais cette dégradation n'affecte que très légèrement les performances de l'élément photosensible. D'autre part, on constate un retour aux performances avant irradiation lorsque l'élément photosensible est soumis à un traitement thermique à basse température, par exemple à une température de l'ordre de 80°C pendant quelques heures.

Le matériau, de par sa structure amorphe, est beaucoup plus absorbant à la lumière que le silicium cristallin. Une couche de 0,5 µm de silicium amorphe hydrogéné absorbe autant de lumière qu'une couche de 300 µm de silicium cristallin. Cette propriété est particulièrement intéressante puisqu'une épaisseur plus faible de matériau est beaucoup plus "transparente" aux rayons γ. L'élément photosensible est donc nettement moins perturbé par le rayonnement parasite et pourra ainsi fonctionner à fort débit de dose.

La présente invention peut donc avantageusement s'appliquer dans les industries nucléaires et également dans le domaine spatial.

## Revendications

1. Structure photosensible destinée à capter la lumière et à délivrer un signal électrique représentatif de la lumière captée, la structure présentant une résistance aux rayonnements électromagnétiques durs, caractérisée en ce qu'elle comporte un élément photosensible en silicium amorphe hydrogéné (1 ; 101) et des moyens (3, 4 ;103, 104) pour recueillir les charges électriques induites par effet photoélectrique dans ledit élément photosensible captant la lumière et pour délivrer ledit signal électrique.

2. Structure photosensible selon la revendication 1, caractérisée en ce que l'élément photosensible en silicium amorphe hydrogéné constitue une jonction présentant une zone déplétée.

3. Structure photosensible selon la revendication 2, caractérisée en ce que l'élément photosensible en silicium amorphe hydrogéné constitue une jonction bipolaire de type p-i-n (1 ; 101).

4. Structure photosensible selon la revendication 3, caractérisée en ce que, la jonction bipolaire de type p-i-n présentant à la lumière à capter la succession de couches p, i et n (11, 12, 13 ; 111, 112, 113), l'épaisseur de l'élément photosensible (1 ; 101) est comprise entre 0,5 et 2 µm.

5. Structure photosensible selon la revendication 4, caractérisée en ce que la couche **p** a une épaisseur de l'ordre de 10% de l'épaisseur de l'élément photosensible.

6. Structure photosensible selon l'une des revendications 4 ou 5, caractérisée en ce que la couche **p** de la jonction bipolaire est en alliage de silicium et de carbone.

7. Structure photosensible selon l'une quelconque des revendications 4 à 6, caractérisée en ce que lesdits moyens pour recueillir les charges électriques et pour délivrer ledit signal électrique comprennent une électrode transparente à la lumière (3 ; 103) déposée sur la face de l'élément photosensible recevant la lumière à capter et une électrode (4 ; 104) déposée sur l'autre face de l'élément photosensible.

8. Dispositif photosensible caractérisé en ce qu'il comprend au moins une structure photosensible selon l'une quelconque des revendications 1 à 7 connectée électriquement à des moyens électroniques de traitement dudit signal électrique.

9. Dispositif photosensible selon la revendication 8, caractérisé en ce qu'il comporte une pluralité de structures photosensibles (220, 230, 240) pour constituer un capteur optique.

10. Dispositif photosensible selon la revendication 9, caractérisé en ce que les structures photosensibles (1) sont connectées électriquement aux moyens électroniques de traitement (5) par l'intermédiaire de billes conductrices (8).

11. Dispositif photosensible selon la revendication 9, caractérisé en ce que les structures photosensibles (101) sont déposées directement sur les moyens électroniques de traitement (105) réalisant ainsi la connexion électrique entre les structures photosensibles et les moyens électroniques de traitement.

12. Dispositif photosensible selon la revendication 11, caractérisé en ce que, les éléments photosensibles (220, 230, 240) étant des jonctions bipolaires de type p-i-n, l'une des couches **p** ou **n** de chacune de ces jonctions fait partie respectivement d'une couche **p** ou **n** commune pour chaque jonction.

13. Dispositif photosensible selon la revendication 12, caractérisé en ce que la couche commune (211) est une couche **p**.

14. Dispositif photosensible selon l'une quelconque des revendication 8 à 13, caractérisé en ce que, les éléments photosensibles étant des jonctions bipolaires de type p-i-n, des moyens sont prévus pour polariser ces jonctions en inverse.

15. Application du dispositif photosensible selon l'une quelconque des revendications 9 à 14 pour constituer le capteur optique d'une caméra vidéo.

16. Procédé de traitement d'un élément photosensible en silicium amorphe hydrogéné ayant été soumis à une irradiation par des rayonnements électromagnétiques durs pour lui restituer ses performances avant irradiation et qui ont été dégradées par cette irradiation, caractérisé en ce qu'il consiste à chauffer l'élément photosensible.

17. Procédé de traitement selon la revendication 16, caractérisé en ce qu'il consiste à chauffer l'élément photosensible à une température de l'ordre de 80°C pendant quelques heures.
